# EUROPEAN PATENT APPLICATION

(11) **EP 1 107 337 A2**
(43) Date of publication of application: **13.06.2001**
(21) Application number: 00310664.8
(22) Date of filing: 30.11.2000
(51) Int. Cl.: H01M 2/10, H01M 2/20

(54) **Battery connector for mounting to a circuit board**

(30) Priority: 30.11.1999 JP 34041399
(71) Applicant: Tyco Electronics AMP K. K., Kawasaki, Kanagawa 213-8535 (JP)
(72) Inventor: Kodaira, Kazuaki, Kanagawa 231-0859 (JP)
(74) Representative: Warren, Keith Stanley

(57) **Abstract**

A battery connector (10) comprises a housing (100) for holding a battery, a first contact (200) which is fastened to the housing in a position on a board side of the housing and which elastically contacts the battery held by the housing, and a second contact (300) which is fastened to the housing and which elastically contacts a different surface ofthe battery from the surface contacted by the first contact. The battery accommodating opening (P) formed by the housing (100), the first contact (200) and the second contact (300) is freely expandable, accommodates the battery in a position extending along the board, and is smaller in size than the battery.

## Description

The present invention relates to an electrical connector and, more particularly, to an electrical connector for connecting a battery to a circuit board.

Generally, button type batteries (hereafter referred to as "button batteries") are widely used as memory retention power supplies in portable electronic devices, such as, telephones, personal data assistants, personal computers, etc. Button batteries that are mounted in these electronic devices, are mounted and connected to a board inside the device.

One such battery connector is described in Japanese Patent Application Kokai No. H10-188932. It accommodates a button battery from a direction perpendicular to the mounting surface of the board to make a secure electrical connection between the button battery and the board.

In the case of current portable electronic devices, greater compactness is desired in order to improve portability, and various configurations have been employed for the disposition of the board inside the device in order to make the device more compact.

In the manufacturing of such devices, there are cases in which the mounting of the button battery in the battery connector installed in the board is performed after the board has been installed inside the device. In such cases, depending on the disposition of the board, it is often found that as a result of the device being made compact, sufficient space is not preserved in the direction perpendicular to the mounting surface of the board, so that it may be difficult to push the button battery into the battery connector. This problem occurs when parallel boards are stacked in close proximity to each other or when board are located close to other components in the device.

In light of the above facts, an object of the present invention is to provide a battery connector which makes it possible to mount the battery in a different direction from a direction perpendicular to the mounting surface of the board, while maintaining the certainty of the electrical connection and the battery holding characteristics to a degree comparable to or exceeding that achieved in conventional devices.

A battery connector for mounting to a circuit board is provided having a housing, a first contact and a second contact. The housing has a pair of resilient arms disposed on opposite sides to define part of a battery accommodating opening. The first contact is positioned in the housing and extends along a major surface of the circuit board. The second contact is spaced apart from the first contact and substantially covers the housing. The battery accommodating opening is formed by the resilient arms, the first contact and the second contact.

The invention will now be described by way of example with reference to the accompanying drawings, in which:

Figure 1 is a perspective view illustrating a battery connector according to the present invention.

Figure 2 is a schematic structural diagram of the battery connector of Figure 1.

Figure 3 is a sectional view along line A-A in Figure 2.

Figure 4 (a) is a diagram which illustrates the positional relationship of the housing 100 and first contact 200.

Figure 4 (b) is a diagram which illustrates the positional relationship in an alternative embodiment of the housing and first contact.

Figure 5 is a plan view of the battery connector of a second alternative embodiment, showing the battery connector with the second contact removed.

Figure 6 is a sectional view along line B-B in Figure 5.

Figure 7 is a perspective view which illustrates a battery connector constituting a third alternative embodiment of the present invention.

Figure 8 is a plan view of the battery connector of Figure 7.

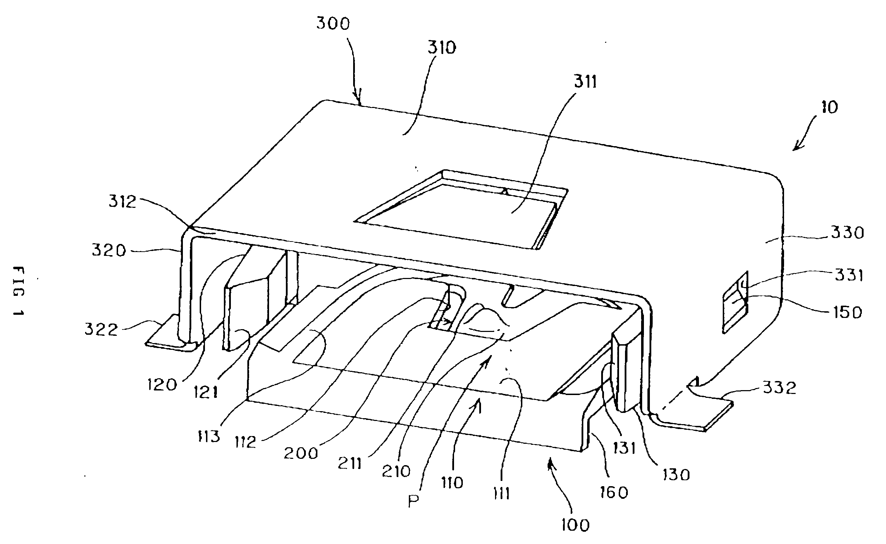

The battery connector 10 shown in Figure 1 has a housing 100, a first contact 200 and a second contact 300. The housing 100 is an insulating member that is preferably molded from a resin; this housing has a retention section 110 that holds a round button battery (not shown in the figures), and also has a pair of arms 120, 130 on the left and right. This pair of arms 120, 130 will be further described below. A base surface 111, a through-hole 112 and a first stop 113 are provided in the retention section 110. The first stop 113 is a tapered surface that rises form the base surface 111.

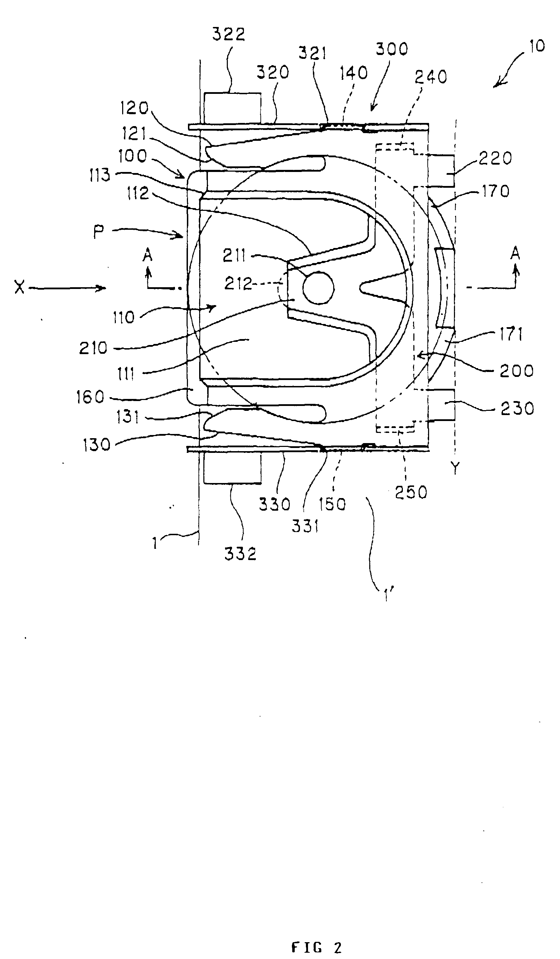

The housing 100 is disposed on the mounting surface 1' of the board 1. This housing 100 has a retention section 110, a pair of arms 120 and 130, and a catch 160. Furthermore, only the claw 150 formed on the lower outer circumferential wall part in Figure 2 is shown in Figure 1; in Figure 2, however, it is shown that the housing 100 also has a claw 140 on the other outer circumferential wall.

The arms 120 and 130 respectively extend toward the battery accommodating opening P from points near the centers of both ends of the retention section 110. These arms 120 and 130 have shapes that conform to the side surfaces of the button battery (see the two-dot chain line in Figure 2), and make surface contact with the side surfaces of the button battery.

Second stops 170 and 171 are respectively connected to the rear ends of the arms 120 and 130. The second stops 170 and 171 prevent the accommodated battery from falling out of the rear end of the battery connector 10. These second stops 170 and 171 are walls that are disposed in upright positions with shapes that conform to the external shape of the button battery. Furthermore, the second stops 170 and 171 are cut out at the rear end. This cut-out functions as a battery push-out space that is used when the button battery is removed from the battery connector 10.

The first stop 113, which is a tapered surface that rises from the base surface 111, has a U shape with the battery accommodating opening P as the head. Accordingly, the first stop 113 serves to urge the button battery toward the base surface 111, and serves together with the second stops 170 and 171 to prevent the battery from falling out of the rear end of the battery accommodating opening P.

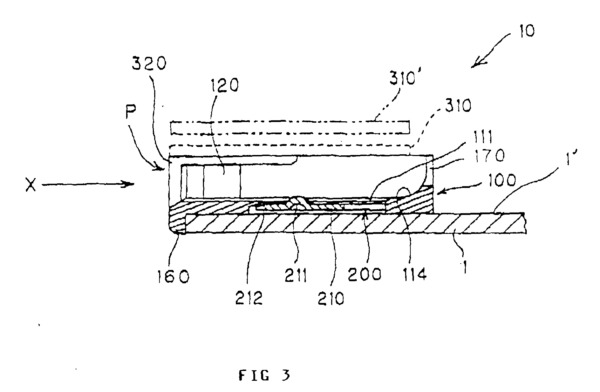

A curved surface 114 whose shape corresponds to the curved portion of the circumference of the battery protrusion is formed on the rear end of the retention section 110 (see Figure 3). Accordingly, backward insertion of the battery can be prevented by means of this curved surface 114. The battery connector 10 is preferably configured to accommodate a circular button battery. The button battery (not shown in the figures) that can be mounted in the battery connector 10 has an electrode on one surface hereafter referred to as the "board-side electrode". A circular protrusion hereafter referred to as the "battery protrusion" is formed on the board-side electrode. The second surface of the button battery has a different shape and contains an electrode that has the opposite polarity from that of the board-side electrode.

The shape of the retention section 110 is preferably complementary to the shape of the surface of the above-mentioned button battery. The battery protrusion is engaged by the base surface 111 and the first stop 113. The base surface 111 and the first stop 113 are preferably contoured to prevent the button battery from being inserted in an incorrect orientation. For example, the battery can not be inserted up side down because the second surface has a shape that does not conform to the first stop 113. Claw parts 150 are disposed on the outer circumferential side walls of the housing 100. In Figure 1, only the claw part 150 disposed on the right outer circumferential side wall of the housing 100 is shown; however, a claw part is also similarly disposed on the left outer circumferential side wall of the housing 100. A catch 160 which is bent toward the base plate (not shown in the figures) is formed on the mating end of the housing 100.

The first contact 200 will now be described in greater detail with reference to Figures 1-3. Note that in Figure 2 the second contact 300 has been removed for illustration purposes and a battery is shown in the inserted position. The arrow "X" indicates the insertion direction. The first contact 200 is a single conductive plate-formed member. This member is installed on the opposite side of the board from the battery accommodating opening P, and has a battery contact section 210, two board connection terminals 220 and 230 (Figure 2), and two securing members 240 and 250. In Figure 1, a portion of the battery contact section 210 of the first contact 200 is shown in the through hole 112. This battery contact section 210 has a dimple 211 that protrudes toward the button battery (not shown in the figures). The battery contact section 210 establishes an electrical connection with the board-side electrode of the button battery.

The first contact 200 is fastened to the housing 100 by the securing members 240 and 250 disposed on ends of the first contact 200. These securing members 240,250 are press-fitted from the board side into a recess in the housing 100 shown in phantom in Figure 2. The battery contact section 210 is disposed on the board side between the two securing members 240 and 250 and is bent toward the battery accommodating opening P. The dimple 211 on the battery contact section 210 projects into the battery accommodating opening through hole 112 to electrically engage the battery protrusion upon insertion. The tip 212 is covered by the base surface 111 of the housing to prevent stubbing with the button during insertion.

The two board connection terminals 220 and 230 are respectively terminated on the mounting surface 1' of the board 1 as shown in Figure2 and 3. These board connection terminals 220 and 230 establish an electrical connection with circuits and traces on the board 1. It should be understood that the positions of the board connection terminals 220, 230 may be appropriately altered according to the relationship with the mating board 1

Referring again to Figure 1, the second contact 300 is a single plate formed member which has a C shape as viewed from the front. This contact 300 has a top plate 310, and side walls 320 and 330 that are respectively located on both sides. Engaging windows are formed in the side walls 320 and 330. Although only one side wall 330 is shown in Figure 1, an engaging window is also similarly formed in the left side wall 320. Similarly shown in Figure 1, the right claw 150 of the housing 100 is engaged with the right engaging window 331 of the second contact 300; however, a claw which is not shown in the figures is also engaged with the other engaging window on the left side wall 320 so that the second contact 300 is fastened to the housing 100. Board connection terminals 322 and 332 which make electrical connections with the board extend from the side walls 320 and 330. Moreover, a battery contact member 311 is formed in the top plate 310 by cutting out a portion of the top plate 310 and bending this portion so that it protrudes downwardly. This battery contact member 311 is inclined toward the housing, and elastically contacts roughly the central portion of the electrode disposed on the opposite surface of the button battery (not shown in the figures) from the surface on which the board-side electrode is disposed. Accordingly, the second contact 300 elastically contacts a different surface of the button battery from the surface contacted by the first contact 200.

The battery accommodating opening P is defined by the edge 312 of the top plate 310 of the second contact 300, the respective free ends 121 and 131 of the pair of arms 120 and 130 of the housing 100, and the catch 160 of the housing 100.

As best shown in Figure 3, the second contact 300 is replaceable with an alternative second contact having a different top plate 310'. This interchangeable alternative second contact is profiled to be secured to the housing 100 in the same way as the second contact. The second contact which has this top plate 310 is used for button batteries having a height equal to or less than the height of the housing 100. On the other hand, the two-dot chain line shown in Figure 3 indicates the top plate 310' of the alternative second contact that is used for button batteries whose height is greater than the height of the housing 100. Button batteries that have the same diameter but different heights can easily be handled by substituting the second contact, so that it is unnecessary to replace the housing 100.

Next, mating of a battery with the battery connector 10 will be described. The gap between the respective free ends 121 and 131 of the arms 120, 130 is smaller than the diameter of the button battery to be mated. However, when an external force is applied to push the button battery into the battery connector 10, through the battery accommodating opening P, the respective free ends 121 and 131 of the arms spread outward as a result of the elasticity of the arms. Accordingly, the battery accommodating opening P widens so that the button battery is accommodated in the interior of the battery connector 10. During this accommodation, the catch 160 engages the edge part of the board 1 (see Figure 3). Accordingly, upward movement of the housing 100 by the insertion of the button battery is prevented. The button battery inserted into the battery connector is guided by the first stop 113, and is inserted to a position in which further insertion is prevented by the first stop 113 and second stops 170 and 171. Following the completion of this insertion, the button battery is held by the retention section 110. Furthermore, since the side surfaces of the button battery are clamped by the arms 120 and 130, the button battery is held more firmly, so that the battery is prevented from slipping out of the battery accommodating opening P.

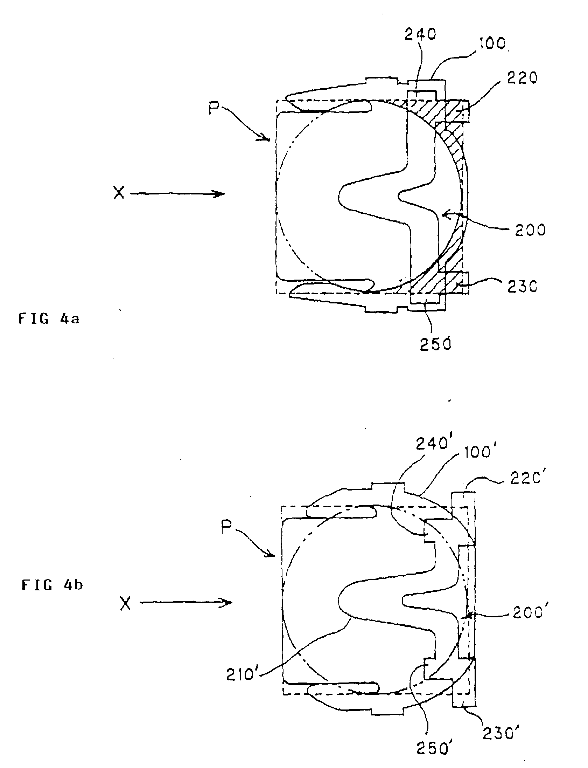

Figure 4 (a) shows a diagram which illustrates the positional relationship of the housing 100 and first contact 200 for the first embodiment. Figure 4 (b) is shows a diagram which illustrates the positional relationship for an alternative housing and first contact. In both of these figures, the circular button battery is indicated by a two-dot chain line, and a square shape that circumscribes the circular button battery is indicated by a dotted line. Furthermore, the respective arrows X shown in the figures indicate the insertion direction of the button battery into the battery connector.

In the first embodiment, as is shown in Figure 4 (a), the securing members 240 and 250 of the first contact 200, and the board connection terminals 220 and 230, which extend in the direction of battery mating, are disposed in the vicinity of the rear end. The board connection terminals 220, 230 are surrounded by a square shaped portion of the hosing that also circumscribes the circular button battery (the shaded region in the figures). In this first embodiment, the battery connector 10, as a whole, is made more compact by using this region without any waste and, in particular, the battery connector is made more compact in the direction of battery mating, as is indicated by the dotted line Y in Figure 2.

Alternatively, the housing 100' shown in Figure 4 (b) differs in shape from the housing 100 of first embodiment. Accordingly, this housing will be described using the names of the respective constituent parts used in the first embodiment. The external shape of the housing 100' of this alternative embodiment differs in that the arm pivoting shaft extending between the arms 240, 250 has an arcuate shape that is concentric with the held button battery. Furthermore, the first contact 200' also differs in shape from the first contact 200 of the first embodiment. This alternative first contact 200' consists of a single plate-formed member and has a battery contact section 210' that is bent toward the battery accommodating opening P. This alternative first contact 200' also has respective board connection terminals 220' and 230' and securing members 240' and 250' located at both ends. While the board connection terminals in the first embodiment extend in the mating direction, the board connection terminals in this alternative embodiment extend outwardly from the sides parallel to the battery accommodating opening P.

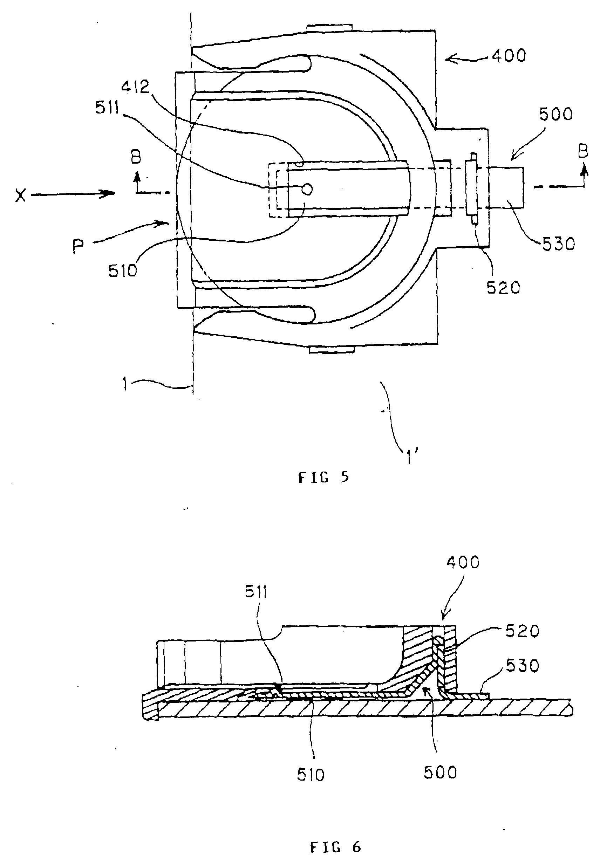

Next, a second alternative embodiment will be described with reference to Figures 5 and 6. The battery connector of this second alternative embodiment is also a battery connector for circular button batteries. The battery connector shown in Figures 5 and 6 with the second contact removed is disposed on the mounting surface 1' of a board 1, and the respective arrows X shown in the figures indicate the mating direction. The battery connector accommodates the button battery along the mounting surface 1' of the board 1 via the battery accommodating opening P.

The battery connector of the second alternative embodiment also has a housing 400, a first contact 500 and a second contact. This battery connector differs from the battery connector 10 of the first embodiment only in that the shape of the first contact and the shape of the housing are different; the shape of the second contact is the same. As in the first embodiment, the first contact 500 consists of a conductive single plate-formed member, and this first contact 500 has a battery contact member 510, a securing member 520 and a board connection terminal 530. However, this first contact 500 differs from the first contact of the first embodiment in that this contact 500 extends linearly from the rear end. As in the first embodiment, the battery contact member 510 has a dimple 511 and is disposed on the back surface of the housing 400. However, the shape of this battery contact member 510 is a linear shape instead of a curved shape. Furthermore, the securing member 520 consists of a single part, and is a part that rises from the battery contact member 510 in the opposite direction from the board 1 on the rear side of the central portion of the battery accommodating opening P. The first contact 500 is fastened to the housing 400 by the press-fitting of the above-mentioned securing member 520 into the housing 400. The board connection terminal 530 protrudes from the housing 400 in the mating direction and is electrically connected to the board 1. In the first contact 500 constructed as described above, the securing member 520 is fastened to the housing 400.

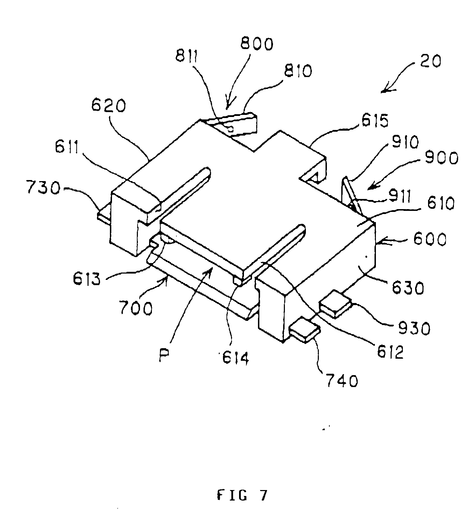

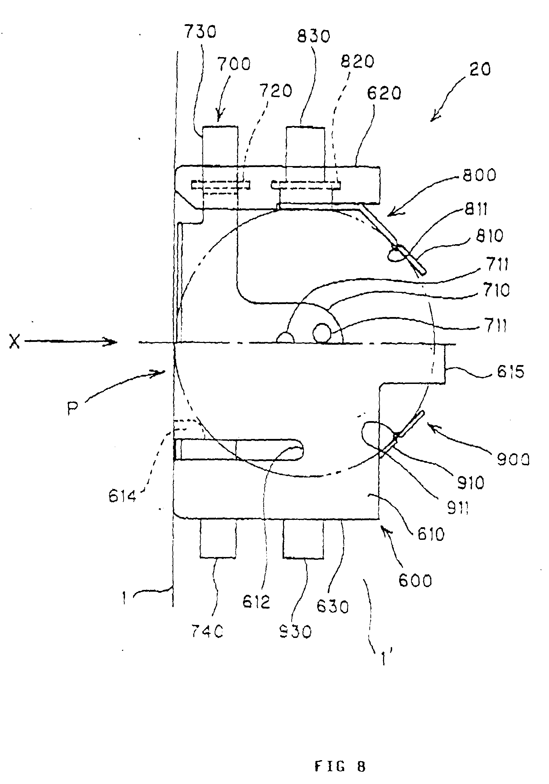

Next, a third alternative embodiment of the present invention will be described with reference to Figures 7 and 8.

The battery connector of this third embodiment is also a battery connector for circular button batteries. The battery connector 20 shown in Figure 8 is disposed on the mounting surface 1' of a board 1, and the arrow X shown in Figure 8 indicates the mating direction of the button battery in the battery connector 20. The battery connector 20 accommodates the button battery along the mounting surface 1' of the board 1 via the battery accommodating opening P. Furthermore, the two-dot chain line in Figure 8 indicates the circular button battery held in the housing. This button battery has the same structure as the button battery used in the description of the first embodiment.

The battery connector 20 of the third alternative embodiment has a housing 600, a first contact 700 and second contacts 800 and 900. The battery accommodating opening P which accommodates the button battery along the mounting surface 1' of the board 1 is formed by the housing 600 and the first contact 700. The battery connector 20 of this third alternative embodiment differs from the two embodiments described above in that the second contacts 800 and 900 consist of two plate-formed members, the housing 600 covers the button battery on the opposite side from the board 1, and the first contact 700 forms the battery accommodating opening P together with the housing 600. Specifically, in this embodiment, the housing 600 is molded from a resin in the form of a "C" shape as viewed from the front. This housing 600 has a top plate 610 and respective side walls 620 and 630 at both ends. Cut-outs 611 and 612 that extend in the mating direction are respectively formed in the top plate 610 at both ends of the battery accommodating opening P. The housing 600 is preferably made of a resin and the part located between the two cut-outs 611 and 612 forms an elastic part that bends in the direction perpendicular to the mounting surface 1' of the board 1. Furthermore, protrusions 613 and 614 extend into the battery accommodating opening P near the two cut-outs 611 and 612. A battery stop 615 extends in the mating direction from the rear end of the top surface 610 and the end portion of this battery stop 615 is bent toward the board 1. This battery stop 615 prevents the battery from slipping out the rear end of the battery accommodating opening P.

The space between the first contact 700 and protruding parts 613 and 614 that form the battery accommodating opening P is narrower than the height of the button battery that is being inserted. However, when an external force is applied to push the button battery into the interior of the battery connector 20, through the battery accommodating opening P, the portion located between the two cut-outs 611 and 612 bends. As a result, the battery accommodating opening P widens so that the button battery can be accommodated inside the battery connector 20. The button battery that has been inserted into the battery connector 20 is prevented from being over inserted by the battery stop 615, so that the battery is held in place. Furthermore, the button battery is secured in the battery accommodating opening P by the protruding parts 613 and 614.

The first contact 700 laterally bridges the space between the side walls 620 and 630 of the housing 600 on the board side. This first contact 700 consists of a single conductive plate-formed member, and has a battery contact member 710, securing members 720 and board connection terminals 730 and 740. The securing members 720are disposed at both ends of the first contact 700 and are fastened in place by being press-fitted in to respective side walls 620 and 630 of the housing. The battery contact member 710 protrudes in the mating direction from the central part of the first contact 700. This battery contact member 710 is positioned on the same plane as the securing members press-fitted in the housing 600. Furthermore, as in the above-mentioned first and second embodiments, the battery contact member 710 has dimples 711 which are electrically connected to the board-side electrode of the button battery. However, three of these dimples 711 are formed so that the electrical connection is made even more secure. The board connection terminals 730 and 740 are respectively connected to the securing members and are disposed so that they protrude from the housing 600 at both ends of the battery accommodating opening P. These board connection terminals 730, 740 are soldered to the mounting surface 1' of the board 1. This first contact 700 constitutes a part of the battery accommodating opening P, and is formed with a taper at the mating end, so that stubbing with the button battery during insertion is prevented. The first contact 700 may be folded back toward the board side to further prevent stubbing of the button.

The second contacts 800 and 900 are disposed further to the rear than the first contact 700. Furthermore, the second contacts 800 and 900 consist of two plate-formed members which are respectively formed by bending; these two plate-formed members have the same structure, and have mirror symmetry. Specifically, the two second contacts 800 and 900 respectively have battery contact members 810 and 910, securing members 820 and board connection terminals 830 and 930. The securing members are respectively disposed at one end of each second contact and are fastened in place by being press-fitted into portions of the side walls of the housing 600. Furthermore, the battery contact members 810 and 910 are connected to the securing members and are folded back 90 degrees so that these battery contact members 810 and 910 are oriented perpendicular to the mounting surface 1' of the board 1. These battery contact members 810 and 910 extend obliquely rearward toward the center of the battery accommodating opening from the rear ends of the side walls 620 and 630 and have protrusions 811 and 911. These protrusions 811 and 911 are installed in such positions that they contact the side surfaces of the button battery inserted into the battery connector 20 before the button battery is engaged by the battery stop 615. Accordingly, the second contacts 800 and 900 elastically contact a different surface of the button battery from the surface that is contacted by the first contact 700. Furthermore, as in the case of the first contact, the board connection terminals 830 and 930 are connected to the securing members, and protrude from the housing 600 in the length direction of the battery accommodating opening P. These board connection terminals 830 and 930 are soldered to the mounting surface 1' of the board 1.

Respective embodiments of the present invention were described above; however, the battery connector of the present invention is not limited to circular button batteries, and may be applied to button batteries of any shape.

As described above, the present invention provides a battery connector which makes it possible to mount the battery in a different direction from the direction perpendicular to the mounting surface of the board, while maintaining the certainty of the electrical connection and the battery holding characteristics to a degree comparable to or exceeding that achieved in conventional devices.

## Claims

1. A battery connector (10) for mounting to a circuit board (1), comprising a housing (100) having a pair of resilient arms (120, 130) disposed on opposite sides, a first contact (200) positioned in the housing (100) for extending along a major surface of the circuit board 1, a second contact (300) spaced apart from the first contact (200) and substantially covering the housing (100), and a battery accommodating opening (P) formed by the resilient arms (120, 130), the first contact (200) and the second contact (300).

2. The battery connector of claim 1 wherein the housing includes retention section (110).

3. The battery connector of claim 2 including a first stop (113) positioned on the retention section (110).

4. The battery connector of claim 3wherein the first stop (113) has a tapered surface which is complementary to an inserted battery.

5. The battery connector of claim 3 or 4wherein the housing includes second stops (170, 171) positioned between the resilient arms (120, 130).

6. The battery connector of any preceding claim wherein the first contact includes securing means (240, 250) which is press fit into the housing.

7. The battery connector of any preceding claim wherein the first contact (200) includes one or more board connection terminals (220,230) for engaging a trace or traces on the circuit board (1).

8. The battery connector of claim 7 wherein the or each first board connection terminal (220, 230) extends rearwardly of the second contact.

9. The battery connector of claim 7 or 8 wherein the or each board connection terminal (220,230) extends rearwardly from a rear end of the first contact (200).

10. The battery connector of any preceding claim wherein the first contact (200) includes one or more dimples (211) extending in to the battery accommodating opening for electrically engaging a battery.

11. The battery connector of any preceding claim wherein the housing has one or more claws (140, 150) disposed on its side walls.

12. The battery connector of claim 11 wherein the second contact (300) includes one or more windows (331) engaged with the claw(s) (140, 150).

13. The battery connector of any preceding claim wherein the second contact (300) includes one or more second board connection terminals (322, 332) for electrically engaging a trace or traces on the circuit board.

14. The battery connector of claim 13 wherein the or each second board connection terminal extends from a side of the second contact.

15. The battery connector of any preceding claim wherein the second contact (300) comprises a top plate (310) having a battery contact member (311) extending therefrom into the battery accommodating opening (P).

16. The battery connector of any preceding claim 1 to 14 wherein the housing includes a top plate (610) connected to side walls (620, 630).

17. The battery connector of claim 16 wherein cut outs (611, 612) are formed in the top plate to define a resilient section.

18. The battery connector of claim 17 wherein a protrusion (613, 614) extends from the resilient section into the battery accommodating opening.

19. The battery connector of any preceding claim 16 to 18 wherein a stop (615) extends from the top plate.

20. A battery connector (10) which accommodates a button type battery in a battery accommodating opening (P) so that the battery and board (1) are electrically connected, characterized in that the battery connector (10) is equipped with a housing (100) which holds the battery, a first contact (200) which is positioned on the board side of the housing and which elastically contacts the battery, a second contact (300) which is fastened to the housing and which elastically contacts a different surface of the battery, and the battery accommodating opening (P) has a freely expandable dimension formed by the housing, the first contact and the second contact, said opening accommodating the battery in a position which extends along the board, and said opening being smaller in size than the battery.

21. The battery connector of claim 20 wherein the second contact (200) covers the battery held by the housing on the opposite side of the battery from the board.

22. The battery connector of claim 20 or 21 wherein the first contact (200) consists of a single plate member which has a battery contact member (211) that bends toward the battery accommodating opening.

23. The battery connector of claim 20, 21 or 22 wherein the housing (100) has a pair of arms (120, 130) which contact the side surfaces of the battery, and the respective free ends (121, 131) of the pair of arms form parts of members that constituting the battery accommodating opening.

24. The battery connector claimed in claim 23 wherein board connection terminals (322, 332) which make a connection with the board and fastening parts which are fastened to the housing are respectively disposed at both ends of the battery accommodating opening.
